# DEMANDE DE BREVET EUROPEEN

(11) **EP 3 185 288 A1**
(43) Date de publication de la demande: **28.06.2017**
(21) Numéro de dépôt: 16166006.3
(22) Date de dépôt: 19.04.2016
(51) Int. Cl.: H01L 21/8249, H01L 27/06, H01L 29/808, H01L 29/66

(54) **PROCÉDÉ DE FABRICATION D'UN TRANSISTOR JFET AU SEIN D'UN CIRCUIT INTÉGRÉ ET CIRCUIT INTÉGRÉ CORRESPONDANT**

(30) Priorité: 21.12.2015 FR 1562956
(71) Demandeur: STMicroelectronics (Crolles 2) SAS, 38920 Crolles (FR)
(72) Inventeur: JIMENEZ, Jean, 11110 Salles d'Aude (FR)
(74) Mandataire: Casalonga

(57) **Abrégé**

Le procédé de fabrication d'un circuit intégré (CI) du type BiCMOS selon l'invention comprend une réalisation d'au moins un transistor à effet de champ à jonction vertical (T1) comportant une formation d'une zone de canal (ZC) ayant une dimension critique de surface active (D) contrôlée par photolithographie.

## Description

Des modes de mise en oeuvre et de réalisation de l'invention concernent les circuits intégrés, en particulier la fabrication de transistors à effet de champ à jonction (JFET) dans un substrat semiconducteur adapté à des technologies bipolaires et des technologies CMOS (BiCMOS).

Les transistors JFET présentent généralement un faible bruit électrique en sortie, et ont généralement une bonne tenue en haute tension. Par exemple, on trouve des transistors JFET dans les étages d'entrée d'amplificateur opérationnels de précision et à haute impédance d'entrée.

Les transistors bipolaires présentent un gain élevé, une impédance de sortie élevée, et sont performants en hautes fréquences, ce qui permet de les utiliser avantageusement par exemple dans des amplificateurs analogiques hautes fréquences.

D'autre part, les transistors MOS réalisés dans une technologie CMOS présentent généralement une haute impédance d'entrée et sont utilisés notamment dans des circuits logiques en électronique numérique.

La technologie BiCMOS présente les atouts des deux types de technologies (bipolaire et CMOS), et est avantageusement utilisée pour des applications à signaux mixtes (analogiques et numériques).

Cependant les procédés de fabrication de circuits électroniques du type BiCMOS doivent marier les contraintes de production des technologies bipolaire et CMOS, notamment en raison d'étapes distinctes entre les deux technologies.

Jusqu'à présent, l'intégration de transistors JFET dans un circuit intégré BiCMOS implique l'introduction d'étapes supplémentaires dans des procédés de fabrications subissant déjà d'importantes contraintes, provoquant des inconvénients de coût.

Par ailleurs, les transistors JFET actuels sont planaires, présentant des jonctions latérales.

La tension de pincement d'un transistor JFET est directement dépendante de la géométrie de la jonction, et est notamment déterminée par la dimension critique de surface active du canal.

La zone de canal d'un transistor JFET planaire est couramment formée par des couches intercalées de matériaux semiconducteurs dopées, formant un agencement des régions de source, de grilles et de drain du transistor JFET.

Ainsi la taille du canal d'un transistor JFET planaire, notamment sa dimension critique de surface active, est déterminée par des diffusions de dopants et est par conséquent difficile à contrôler et à réguler.

En outre, au sein d'un même procédé de production de transistors JFET planaires, réaliser des transistors JFET ayant des tensions de pincement différentes entre eux nécessite des étapes supplémentaires de masquage et d'implantation.

Selon un mode de réalisation, il est proposé un transistor JFET ayant une zone de canal dont la dimension critique de canal est mieux contrôlée selon un mode de mise en oeuvre et de réalisation.

Selon un mode de mise en oeuvre, il est aussi proposé un procédé de fabrication d'un transistor JFET dans un circuit intégré du type BiCMOS qui n'ajoute pas d'étape supplémentaire à un procédé de fabrication classique de circuit intégré du type BiCMOS.

Selon un aspect, il est proposé un procédé de fabrication d'un circuit intégré comprenant une réalisation d'au moins un transistor à effet de champ à jonction vertical comportant une formation d'une zone de canal ayant une dimension critique de surface active contrôlée par photolithographie.

Ce procédé peut comprendre plusieurs réalisations simultanées de transistors à effet de champ à jonction verticaux dans lesquelles différentes dimensions critiques de surface active des zones de canal d'un transistor à un autre sont contrôlées lors d'une étape commune de photolithographie.

Les procédés de photolithographie classiques et connus étant bien maîtrisés, précis et reproductibles, la dimension critique de la surface active du canal exhibe une très faible variabilité d'une mise en oeuvre du procédé à une autre. Les tensions de pincement des transistors fabriqués par ce procédé exhibent donc également une très faible variabilité.

D'autre part, les procédés de photolithographie sont des étapes courantes dans les procédés de fabrication de circuit électronique et sont facilement modulables. Ainsi, selon cet aspect, il est possible de réaliser plusieurs transistors JFET dont les tensions de pincement sont différentes lors de la mise en oeuvre d'un même procédé, sans étape ni durée supplémentaire.

Par ailleurs le caractère vertical du transistor JFET lui permet de s'insérer facilement dans un procédé de fabrication du type CMOS.

Selon un mode de mise en oeuvre du procédé, ladite formation de la zone de canal comprend la formation, dans un caisson d'un premier type de conductivité, de deux régions de grille d'un deuxième type de conductivité, ladite dimension critique de surface active de la zone de canal étant définie par l'espacement entre lesdites deux régions de grilles.

La réalisation du transistor à effet de champ à jonction vertical peut comprendre en outre une formation de régions de prise de contact de grille du deuxième type de conductivité en contact avec lesdites deux régions de grille.

La réalisation du transistor à effet de champ à jonction vertical peut comprendre en outre une formation d'une région de drain comportant une formation sous ledit caisson d'une couche enterrée du premier type de conductivité plus fortement dopée que ledit caisson et une formation d'un puits de contact du premier type de conductivité et s'étendant depuis la surface du caisson jusqu'à ladite couche enterrée.

La réalisation du transistor à effet de champ à jonction vertical peut comprendre en outre une formation d'une région de source du premier type de conductivité en contact avec ladite zone de canal.

Il est également proposé une mise en oeuvre du procédé selon cet aspect, qui n'ajoute pas d'étape supplémentaire à un procédé classique de fabrication de circuit intégré du type BiCMOS.

Selon ce mode de mise en oeuvre, le procédé comprend en outre des formations, dans des caissons respectifs de type de conductivité adaptés, d'au moins un transistor bipolaire d'un premier type de conductivité, d'au moins un transistor bipolaire d'un deuxième type de conductivité, d'au moins un transistor à effet de champ à grille isolée d'un premier type de conductivité et d'au moins un transistor à effet de champ à grille isolée d'un deuxième type de conductivité, réalisées simultanément avec la fabrication dudit au moins un transistor à effet de champ à jonction vertical.

Chaque étape du procédé de fabrication du transistor JFET vertical peut être avantageusement réalisée simultanément avec une étape classique de fabrication d'un transistor bipolaire de type N (NPN) ou de type P (PNP) et/ou avec une étape classique de fabrication d'un transistor à effet de champ à grille isolée de type N (NMOS) ou de type P (PMOS).

Le procédé peut comprendre la formation de régions d'implantation de champ du deuxième type de conductivité dans les caissons des transistors bipolaires du premier type de conductivité, simultanément avec ladite formation desdites régions de grille.

En effet, les circuits intégrés du type BiCMOS, par exemple présents sur un étage d'entrée d'un amplificateur opérationnel haute tension, doivent parfois supporter des tensions de l'ordre de 40 volts. Réaliser des implantations de champ formées par des tranchées remplies d'un matériau fortement dopé permet d'étaler les lignes de champ plus loin des jonctions actives et ainsi améliorer la tenue en tension des composants du circuit intégré.

Le procédé peut comprendre la formation de régions d'émetteurs de transistors bipolaires du deuxième type de conductivité et/ou de régions de source/drain de transistors à effet de champ à grille isolée du deuxième type de conductivité, simultanément avec ladite formation des régions de prise de contact de grille du transistor JFET.

Le procédé peut comprendre une formation d'une région de collecteur d'un transistor bipolaire du premier type de conductivité comportant une formation d'une couche enterrée du premier type de conductivité plus fortement dopée que le caisson dudit transistor bipolaire et une formation d'un puits de contact du premier type de conductivité s'étendant depuis la surface dudit caisson du transistor bipolaire jusqu'à ladite couche enterrée, simultanément avec ladite formation de la région de drain du transistor à effet de champ à jonction vertical.

Le procédé peut comprendre la formation de régions d'émetteur de transistors bipolaires du premier type de conductivité et/ou de régions de source/drain de transistors à effet de champ à grille isolée du premier type de conductivité, simultanément avec ladite formation de la région de source du transistor à effet de champ à jonction vertical.

La réalisation de régions d'émetteur d'un premier ou deuxième type de conductivité, de régions de source et de drains d'un premier ou d'un deuxième type de conductivité, et de régions de collecteur d'un premier type de conductivité comprenant un puits de contact et une couche enterrée, sont des étapes classiques des procédés de fabrication de circuit intégré du type BiCMOS.

La réalisation du transistor JFET n'introduit à cet égard aucune étape supplémentaire par rapport à un procédé classique.

Selon un autre aspect, il est proposé un circuit intégré comprenant au moins un transistor à effet de champ à jonction vertical, comprenant un caisson semiconducteur d'un premier type de conductivité, une région de drain comportant une couche enterrée du premier type de conductivité plus fortement dopée que ledit caisson et un puits de contact du premier type de conductivité s'étendant depuis la surface du caisson jusqu'à ladite couche enterrée, une région de grille comportant deux tranchées remplies d'un matériau semiconducteur d'un deuxième type de conductivité délimitant une zone de canal, et une région de source du premier type de conductivité au-dessus de ladite zone de canal.

Le circuit intégré peut comprendre en outre au moins un transistor bipolaire d'un premier type de conductivité et au moins un transistor bipolaire d'un deuxième type de conductivité, au moins un transistor à effet de champ à grille isolée d'un premier type de conductivité et au moins un transistor à effet de champ à grille isolée d'un deuxième type de conductivité.

La couche enterrée et le puits de contact de drain du transistor à effet de champ à jonction peuvent être à de mêmes niveaux que des couches enterrées et des puits de contacts des régions de collecteurs des transistors bipolaires.

La région de grille du transistor à effet de champ à jonction peut être à un même niveau que des régions d'implantation de champ de transistors bipolaires du premier type de conductivité.

La région de source du transistor à effet de champ à jonction peut être à un même niveau que des régions d'émetteur de transistors bipolaires du premier type de conductivité et/ou à un même niveau que des régions de drain/source de transistors à effet de champ à grille isolée du premier type de conductivité.

Le transistor à effet de champ à jonction peut comporter des régions de prise de contact de grille du deuxième type de conductivité, et en contact avec lesdites régions de grille, peuvent être situées à un même niveau que des régions d'émetteur de transistors bipolaires du deuxième type.

Selon un mode de réalisation, le circuit intégré comprend une pluralité de transistors à effet de champ à jonction verticaux, les différents transistors à effet de champ à jonction ayant des zones de canal de dimension critiques de surface active différentes d'un transistor à un autre.

Le circuit intégré peut comprendre une pluralité de transistors à effet de champ à jonction formant une structure cellulaire.

Les architectures en structure cellulaire permettent d'éviter de subir des effets de bords contraignants et peu prévisibles apparaissant dans des transistors JFET étendus.

D'autres avantages et caractéristiques de l'invention apparaîtront à l'examen de la description détaillée de modes de réalisation et de mises en oeuvre, nullement limitatifs, et des dessins annexés sur lesquels :

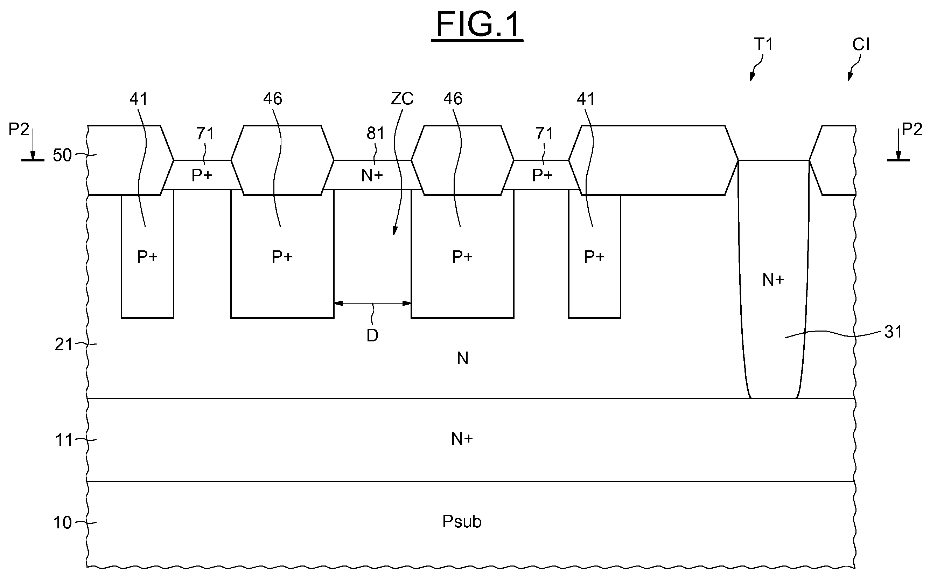

- Les figures 1 à 8 représentent des modes de réalisation et de mise en oeuvre de l'invention.

Par souci de clarté, comme il est courant dans la représentation de circuits intégrés, les figures 1 à 8 sont représentées schématiquement et ne sont pas à l'échelle, les éléments communs d'une figure à une autre sont désignés par de mêmes références.

En outre, dans la suite le premier type de conductivité sera désigné comme étant le type N et le deuxième type de conductivité comme étant le type P, même si l'inverse est également possible selon l'invention.

La figure 1 illustre un exemple d'un transistor à effet de champ à jonction vertical T1, faisant partie d'un circuit intégré CI formé sur un substrat semiconducteur 10 dopé du type P. Ce transistor T1 est réalisé notamment dans un caisson semiconducteur 21 dopé de type N et comprend une région de drain, une région de source 81, une région de grille 46, et une zone de canal ZC.

La région de drain comporte une couche enterrée 11 de type N⁺, plus fortement dopée que ledit caisson 21, et un puits de contact 31 également fortement dopé du type N⁺. Le puits de contact 31 s'étend depuis la surface du caisson 21 jusqu'à ladite couche enterrée 11.

La région de grille 46 comprend deux tranchées verticales voisines remplies d'un matériau semiconducteur fortement dopé du type P⁺. Ces tranchées délimitent la zone de canal verticale ZC entre elles. La distance D entre ces tranchées définit la dimension critique de surface active du canal du transistor.

Des régions de prise de contact de grille 71 fortement dopées du type P sont disposées en surface du caisson 21 et en contact avec lesdites régions de grille 46.

La région de source 81 fortement dopée du type N⁺ est formée au-dessus de ladite zone de canal ZC, également en surface du caisson 21.

En outre, des régions d'oxydation locales 50 sont formées entre les régions de prise de contact de grille 71 et la région de source 81 et entre les régions de prise de contact de grille 71 et le puits de contact de drain 31, afin d'isoler ces régions les unes des autres. De même, des régions d'oxydation locales 50 sont formées aux extrémités latérales de la surface du caisson afin d'isoler le transistor T1 du reste du circuit intégré CI duquel il fait partie.

Ces régions 50 peuvent être du type LOCOS ou bien être des tranchées peu profondes (STI : Shallow Trench Isolation).

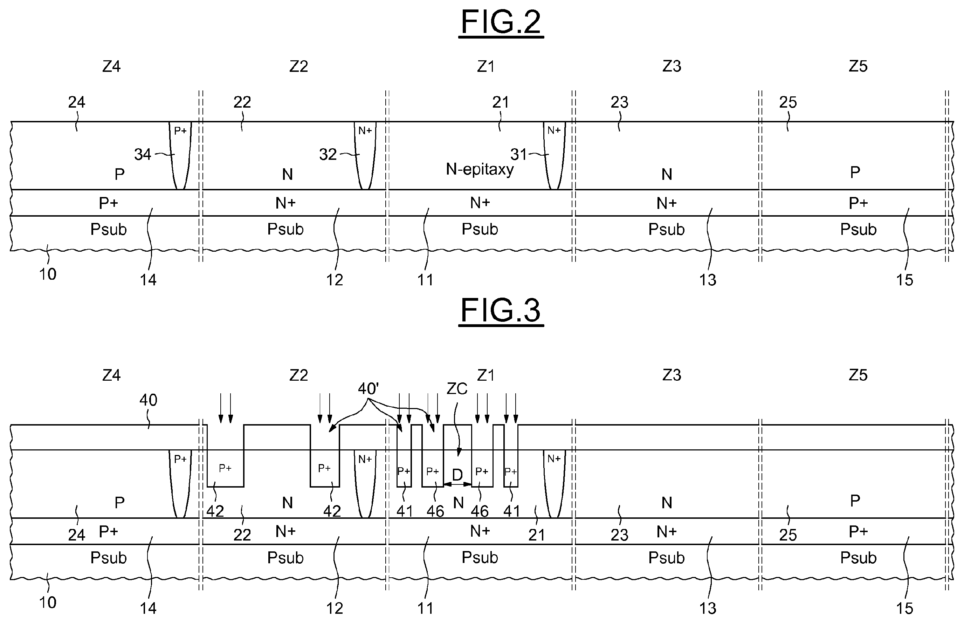

La figure 2 illustre le résultat d'étapes initiales d'un exemple de procédé de fabrication d'un circuit intégré CI selon l'invention. Le circuit intégré CI comporte ici cinq zones Z1, Z2, Z3, Z4, et Z5, délimitées sur les figures suivantes par des traits interrompus, dans lesquelles un transistor JFET T1, un transistor bipolaire de type NPN T2, un transistor à effet de champ à grille isolée de type PMOS T3, un transistor bipolaire de type PNP T4 et un transistor à effet de champ à grille isolée de type NMOS T5 vont respectivement être fabriqués selon un mode de mise en oeuvre de l'invention.

Dans un substrat 10 de silicium dopé de type P, des couches enterrées 11, 12, 13 fortement dopées de type N⁺ ont été formées par implantation peu profonde dans les zones respectives Z1, Z2, Z3 du substrat 10. Des caissons 21, 22, 23 dopés de type N ont été formés par épitaxie respectivement au-dessus de ces couches enterrées 11, 12, 13.

De même, des couches enterrées 14, 15 fortement dopées de type P⁺ ont été formées par implantation peu profonde dans les zones respectives Z4, Z5, sur lesquelles des caissons dopés de type N ont été formés par épitaxie, puis respectivement convertis en caissons 24, 25 dopés de type P par implantation ionique et diffusion des dopants.

Des puits de contact 31, 32 fortement dopés de type N⁺ ont également été formés par implantation dans les caissons 21, 22. Un puits de contact 34 fortement dopé de type P⁺ a été formé par implantation dans le caisson 24.

Chaque puits de contact 31, 32, 34, s'étend de la surface du caisson respectif jusqu'à la couche enterrée respective.

A l'étape suivante, illustrée par la figure 3, une couche de résine de masquage 40 est déposée sur la surface des caissons 21 à 25 puis gravée selon un motif préétabli par photolithographie, découvrant des sites de gravure 40' en surface desdits caissons 21 et 22.

Des tranchées peu profondes sont gravées dans les caissons 21 et 22 à l'emplacement des sites de gravure 40'.

Un matériau semiconducteur fortement dopé de type P⁺ est déposé dans les tranchées, formant des régions d'implantation de champ 41, 42 dans les caissons respectifs 21, 22, et deux régions de grille 46 du futur transistor JFET dans le caisson 21.

On a ainsi formé entre les deux régions de grilles 46 la future zone de canal ZC du transistor JFET, dont la dimension critique de surface active D est contrôlée par photolithographie.

En effet, la diffusion latérale des dopants dans le caisson 21 est négligeable devant la dimension D et ainsi la dimension D est précisément déterminée par la partie correspondante du motif transféré sur la résine.

En outre, la zone de canal ZC a été formée de manière simultanée à des étapes de fabrication des transistors NPN du circuit intégré.

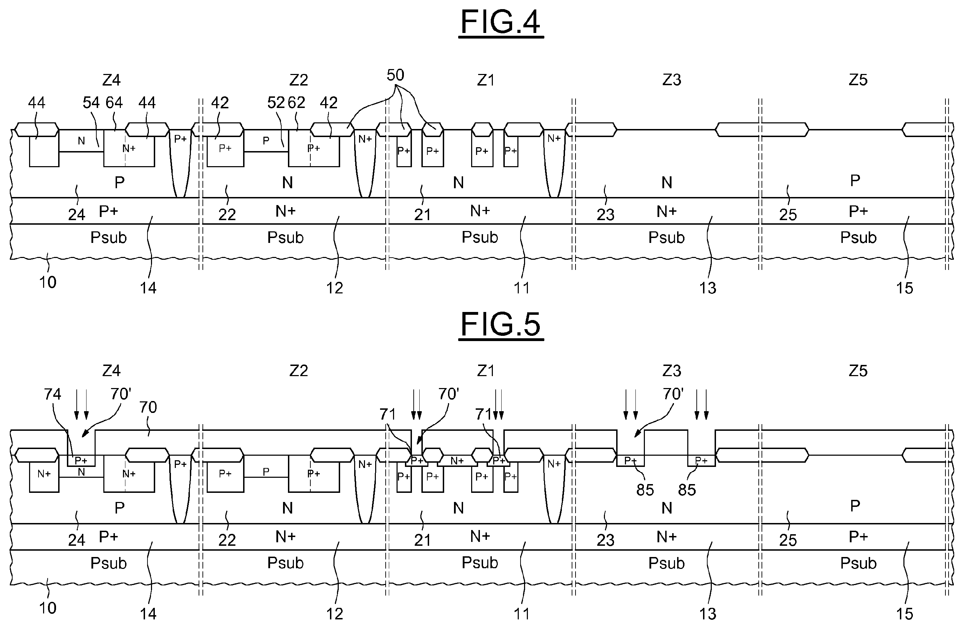

La figure 4 illustre le résultat d'étapes non représentées, parmi lesquelles un second masquage a été réalisé afin former des régions 44 d'implantation de champ dans le caisson 24 avec un matériau fortement dopé du type N.

Des régions actives du circuit intégré CI ont été délimitées par des oxydations locales 50 en surface des caissons 21 à 25, par exemple selon un procédé connu du type LOCOS (acronyme anglo-saxon venant de « LOCal Oxydation of Silicon »).

Des implantations de dopants ont également été réalisées, formant des zones de base intrinsèque 52 et de base extrinsèque 62 respectivement dopée P et fortement dopée de type P⁺ dans le caisson 22, et des zones de base intrinsèque 54 et de base extrinsèque 64 respectivement dopée N et fortement dopée de type N dans le caisson 24.

L'étape suivante, représentée par la figure 5, est une étape de photolithographie commune aux formations des transistors JFET, PMOS et PNP.

Une couche 70 de résine est déposée en surface des caissons 21 à 25 dans laquelle des ouvertures, également réalisées par photolithographie selon un motif préétabli, découvrent des sites d'implantations 70' en surfaces des caissons 21, 23 et 24.

Un dopant de type P est implanté à haute densité et à faible profondeur dans ces sites d'implantations 70', formant simultanément un émetteur 74 du futur transistor PNP, les régions de prise de contact de grilles 71 du futur transistor JFET, et les régions de source et de drain 73 du futur transistor PMOS, dans les caissons correspondant 24, 21 et 23.

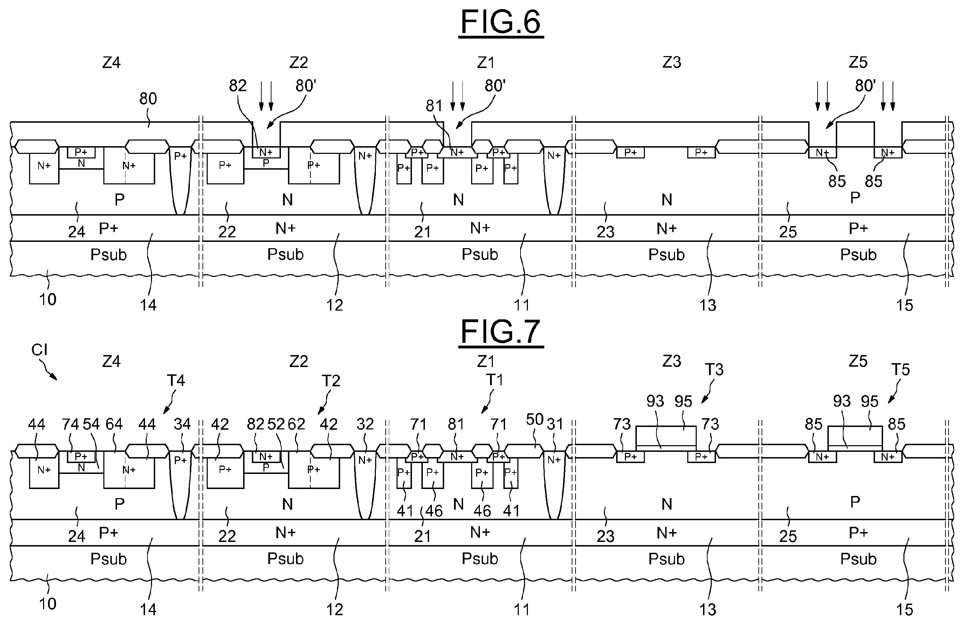

L'étape suivante, représentée par la figure 6, est une étape de photolithographie commune aux formations des transistors JFET, NPN et NMOS.

Une couche 80 de résine est déposée en surface des caissons 21 à 25 dans laquelle des ouvertures, également réalisées par photolithographie selon un motif préétabli, découvrent des sites d'implantations 80' en surface des caissons 21, 22 et 25.

Un dopant de type N est implanté à haute densité et à faible profondeur dans ces sites d'implantations 80', formant simultanément un émetteur 82 du futur transistor NPN, la source 81 du futur transistor JFET, et les régions de source et de drain 85 du futur transistor NMOS.

La figure 7 représente un circuit intégré obtenu selon un mode de mise en oeuvre de l'invention, comportant un transistor à effet de champ à jonction vertical T1, un transistor bipolaire de type NPN T2, un transistor bipolaire de type PNP T4 un transistor PMOS T3 et un transistor NMOS T5. Les grilles isolées des transistors PMOS T3 et NMOS T5 ont été formées de manière classique et comprennent une couche isolante 93, par exemple de l'oxyde de silicium, et une couche de matériau de grille 95, par exemple du silicium polycristallin.

Les étapes suivantes de prise de contact, incluant par exemple des étapes de siliciuration et de dépôt de contacts, sont réalisées de façon classique et ne sont pas représentées.

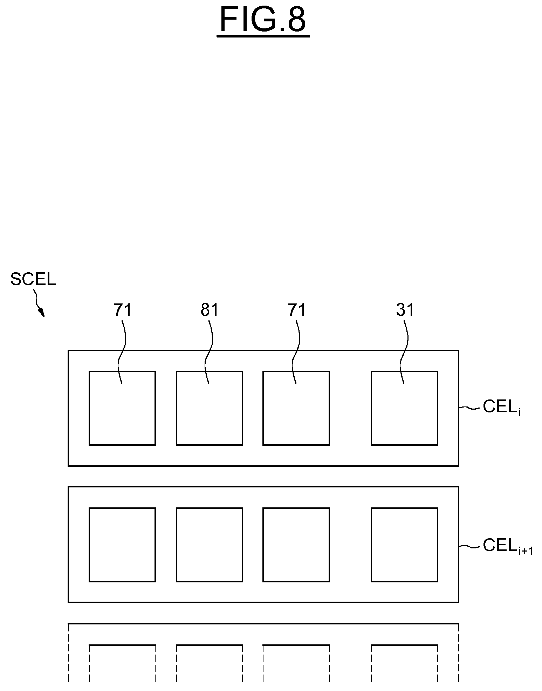

La figure 8 représente schématiquement une architecture en structure cellulaire de transistors JFET du type du transistor T1 représenté sur la figure 1, dans le plan P2, en « vue du dessus ».

La structure cellulaire SCEL comprend plusieurs cellules unitaires CELᵢ, chaque cellule unitaire CELᵢ comprend un transistor JFET comprenant notamment une région de drain 31, deux régions de prise de contact de grille 71 et une région de source 81.

Le courant de drain à saturation est connu et maîtrisé pour chaque cellule unitaire. Ainsi, on peut régler un courant de drain à saturation à une valeur voulue en connectant en parallèle plusieurs cellules unitaires.

Le courant de drain à saturation de la structure cellulaire est alors égal à la somme des courants de drain à saturation de chaque cellule unitaire connectée en parallèle.

L'architecture de transistors JFET en structure cellulaire permet d'éviter la fabrication de transistors JFET plus étendus pour obtenir un courant de drain à saturation plus élevé, les transistors JFET étendus présentant des effets de bord difficiles à maîtriser et à modéliser.

Bien entendu, la présente invention est susceptible de diverses variantes et modifications qui apparaîtront à l'homme de l'art. En particulier, l'invention peut s'appliquer à la fabrication d'un transistor JFET à canal de type P en inversant les types de conductivité correspondants.

## Revendications

1. Procédé de fabrication d'un circuit intégré (CI) comprenant une réalisation d'au moins un transistor à effet de champ à jonction vertical (T1) comportant une formation d'une zone de canal (ZC) ayant une dimension critique de surface active (D) contrôlée par photolithographie.

2. Procédé selon la revendication 1, dans lequel ladite formation de la zone de canal (ZC) comprend la formation, dans un caisson (21) d'un premier type de conductivité, de deux régions de grille (46) d'un deuxième type de conductivité, ladite dimension critique de surface active (D) de la zone de canal étant définie par l'espacement entre lesdites deux régions de grilles (46).

3. Procédé selon la revendication 2, dans lequel la réalisation du transistor à effet de champ à jonction vertical (T1) comprend en outre une formation de régions de prise de contact de grille (71) du deuxième type de conductivité en contact avec lesdites deux régions de grille (71).

4. Procédé selon l'une des revendications 2 ou 3, dans lequel la réalisation du transistor à effet de champ à jonction vertical (T) comprend en outre une formation d'une région de drain comportant une formation sous ledit caisson (21) d'une couche enterrée (11) du premier type de conductivité plus fortement dopée que ledit caisson (21) et une formation d'un puits de contact (31) du premier type de conductivité et s'étendant depuis la surface du caisson (21) jusqu'à ladite couche enterrée (11).

5. Procédé selon l'une quelconque des revendications précédentes, dans lequel la réalisation du transistor à effet de champ à jonction vertical (T1) comprend en outre une formation d'une région de source (81) du premier type de conductivité en contact avec ladite zone de canal (ZC).

6. Procédé selon l'une quelconque des revendications précédentes, comprenant en outre des formations, dans des caissons respectifs de types de conductivité adaptés, d'au moins un transistor bipolaire d'un premier type de conductivité (T2), d'au moins un transistor bipolaire d'un deuxième type de conductivité (T4), d'au moins un transistor à effet de champ à grille isolée d'un premier type de conductivité (T5) et d'au moins un transistor à effet de champ à grille isolée d'un deuxième type de conductivité (T3), réalisées simultanément avec la réalisation dudit au moins un transistor à effet de champ à jonction vertical (T1).

7. Procédé selon les revendications 2 et 6, comprenant la formation de régions d'implantation de champ (42) du deuxième type de conductivité dans les caissons (22) des transistors bipolaires du premier type de conductivité (T2), simultanément avec ladite formation desdites régions de grille (46) du transistor à effet de champ à jonction vertical (T1).

8. Procédé selon la revendication 3 prise en combinaison avec la revendication 6 ou 7, comprenant la formation de régions d'émetteurs (74) de transistors bipolaires du deuxième type de conductivité (T4) et/ou de régions de source/drain (73) de transistors à effet de champ à grille isolée du deuxième type de conductivité (T3), simultanément avec ladite formation des régions de prise de contact de grille (71) du transistor à effet de champ à jonction vertical (T1).

9. Procédé selon la revendication 4 prise en combinaison avec l'une des revendications 6 à 8, comprenant une formation d'une région de collecteur d'un transistor bipolaire du premier type de conductivité (T2) comportant une formation d'une couche enterrée (12) du premier type de conductivité plus fortement dopée que le caisson (22) dudit transistor bipolaire et une formation d'un puits de contact (32) du premier type de conductivité s'étendant depuis la surface dudit caisson (22) du transistor bipolaire (T2) jusqu'à ladite couche enterrée (12), simultanément avec ladite formation de la région de drain du transistor à effet de champ à jonction vertical (T1).

10. Procédé selon la revendication 5 prise en combinaison avec l'une des revendications 6 à 9, comprenant la formation de régions d'émetteur (82) de transistors bipolaires du premier type de conductivité (T2) et/ou de régions de source/drain (85) de transistors à effet de champ à grille isolée du premier type de conductivité (T5), simultanément avec ladite formation de la région de source (81) du transistor à effet de champ à jonction vertical (T1).

11. Procédé de fabrication d'un circuit intégré selon l'une quelconque des revendications précédentes, comprenant plusieurs réalisations simultanées de transistors à effet de champ à jonction verticaux (T1), les différentes dimensions critiques de surface active (D) des zones de canal (ZC) étant contrôlées d'un transistor à un autre lors d'une étape commune de photolithographie.

12. Circuit intégré comprenant au moins un transistor à effet de champ à jonction vertical (T1), comprenant un caisson semiconducteur (21) d'un premier type de conductivité, une région de drain comportant une couche enterrée (11) du premier type de conductivité plus fortement dopée que ledit caisson (21) et un puits de contact (31) du premier type de conductivité et s'étendant depuis la surface du caisson (21) jusqu'à ladite couche enterrée (11), une région de grille (46) comportant deux tranchées remplies d'un matériau semiconducteur d'un deuxième type de conductivité délimitant une zone de canal (ZC), et une région de source (81) du premier type de conductivité au-dessus de ladite zone de canal (ZC).

13. Circuit intégré selon la revendication 12, comprenant en outre au moins un transistor bipolaire d'un premier type de conductivité (T2), au moins un transistor bipolaire d'un deuxième type de conductivité (T4), au moins un transistor à effet de champ à grille isolée d'un premier type de conductivité (T5) et au moins un transistor à effet de champ à grille isolée d'un deuxième type de conductivité (T3).

14. Circuit intégré selon la revendication 13, dans lequel la couche enterrée (11) et le puits de contact (31) de drain du transistor à effet de champ à jonction (T1) sont à des mêmes niveaux que des couches enterrées (12, 14) et des puits de contacts (32, 34) des régions de collecteurs des transistors bipolaires (T2, T4).

15. Circuit intégré selon la revendication 13 ou 14, dans lequel la région de grille (46) du transistor à effet de champ à jonction vertical (T1) est à un même niveau que des régions d'implantation de champ (42) des transistors bipolaires (T2, T4).

16. Circuit intégré selon l'une quelconque des revendications 13 à 15, dans lequel la région de source (81) du transistor à effet de champ à jonction vertical (T1) est à un même niveau que des régions d'émetteur (82) de transistors bipolaire du premier type de conductivité (T2) et/ou à un même niveau que des régions de drain/source (85) de transistors à effet de champ à grille isolée du premier type de conductivité (T5).

17. Circuit intégré selon l'une quelconque des revendications 13 à 16, dans lequel le transistor à effet de champ à jonction vertical (T1) comporte des régions de prise de contact de grille (71), du deuxième type de conductivité, en contact avec lesdites régions de grille (46), et situées à un même niveau que des régions d'émetteur (74) de transistors bipolaires du deuxième type de conductivité (T4), et/ou à un même niveau que des régions de drain/source (73) de transistors à effet de champ à grille isolée du deuxième type de conductivité (T3).

18. Circuit intégré selon l'une quelconque des revendications 12 à 17, comprenant une pluralité de transistors à effet de champ à jonction verticaux (T1), les différents transistors à effet de champ à jonction (T1) ayant des zones de canal (ZC) de dimension critiques de surface active (D) différentes d'un transistor à un autre.

19. Circuit intégré comprenant une pluralité de transistors à effet de champ à jonction vertical (T1) selon l'une quelconque des revendications 12 à 17, formant une structure cellulaire.
